(19) Europäisches Patentamt / European Patent Office / Office européen des brevets

(11) **EP 2 426 563 B1**

(12) **FASCICULE DE BREVET EUROPEEN**

(45) Date de publication et mention
de la délivrance du brevet:
**13.06.2018 Bulletin 2018/24**

(51) Int Cl.:
*G04F 5/14* *(2006.01)*        *G01R 33/26* *(2006.01)*
*G01C 19/62* *(2006.01)*

(21) Numéro de dépôt: **11180128.8**

(22) Date de dépôt: **06.09.2011**

(54) **Procédé de calibration d'un appareil à fonctionnement atomique**

Kalibrierungsverfahren für ein Gerät mit Atomantrieb

Method for calibrating a device with atomic operation

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.09.2010 FR 1057085**

(43) Date de publication de la demande:
**07.03.2012 Bulletin 2012/10**

(73) Titulaire: **Commissariat à l'Énergie Atomique
et aux Énergies Alternatives
75015 Paris (FR)**

(72) Inventeurs:
• **Le Prado, Matthieu**
  **26260 CHARMES SUR L'HERBASSE (FR)**
• **Leger, Jean-Michel**
  **38190 VILLARD BONNOT (FR)**

(74) Mandataire: **Ilgart, Jean-Christophe
BREVALEX
95, rue d'Amsterdam
75378 Paris Cedex 8 (FR)**

(56) Documents cités:
**EP-A1- 0 462 001     EP-A1- 0 964 260
FR-A- 1 354 208**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Le sujet de l'invention est un procédé de calibration d'un appareil à fonctionnement atomique, c'est-à-dire utilisant un pompage optique d'un faisceau lumineux, et comprenant encore des bobines électromagnétiques ; il peut s'agir d'une horloge atomique, d'un magnétomètre ou d'un gyroscope.

Les bobines électromagnétiques sont utilisées de diverses façons dans ces appareils, pour faire des mesures magnétiques ou produire des champs magnétiques artificiels. Un pilotage très précis des bobines est souvent nécessaire pour obtenir des résultats corrects. La calibration des bobines peut englober la fonction de transfert, c'est-à-dire le rapport du champ magnétique qui y est induit en fonction du courant qui les parcourt, et la direction de ce champ par rapport à une direction de référence.

EP-0 462 001-A décrit un magnétomètre à résonance magnétique comprenant trois bobines perpendiculaires entre elles.

On propose ici un procédé de calibration dans lequel aucun appareil supplémentaire n'est employé, pour étalonner les caractéristiques des champs magnétiques induits par les bobines, qui font ainsi une auto-calibration.

Sous une forme générale, l'invention concerne un procédé de calibration d'un appareil de mesure à fonctionnement atomique selon la revendication 1.

Cette forme générale de l'invention est applicable quand le champ magnétique ambiant est négligé, arrêté par un blindage ou compensé par création d'un champ artificiel ou antagoniste. Un procédé de compensation du champ peut comprendre les étapes suivantes :

- génération de deux champs oscillants orthogonaux ;
- génération d'un champ magnétique essentiellement statique par chacune des bobines ;
- compensation du champ ambiant par ledit champ essentiellement statique par réglage magnétique engendré pour chacune des bobines.

Si le champ n'est pas négligeable, le procédé comprend de préférence des caractéristiques de la revendication 3.

Avantageusement, les champs magnétiques sont mesurés par une application de radiofréquences et une recherche d'une résonance du milieu gazeux à une fréquence de Larmor.

L'invention sera maintenant décrite dans le détail de ses différents aspects en liaison aux figures, parmi lesquelles :

- la figure 1 est une vue générale de l'appareil,
- la figure 2 est une définition des angles mesurés entre les bobines.

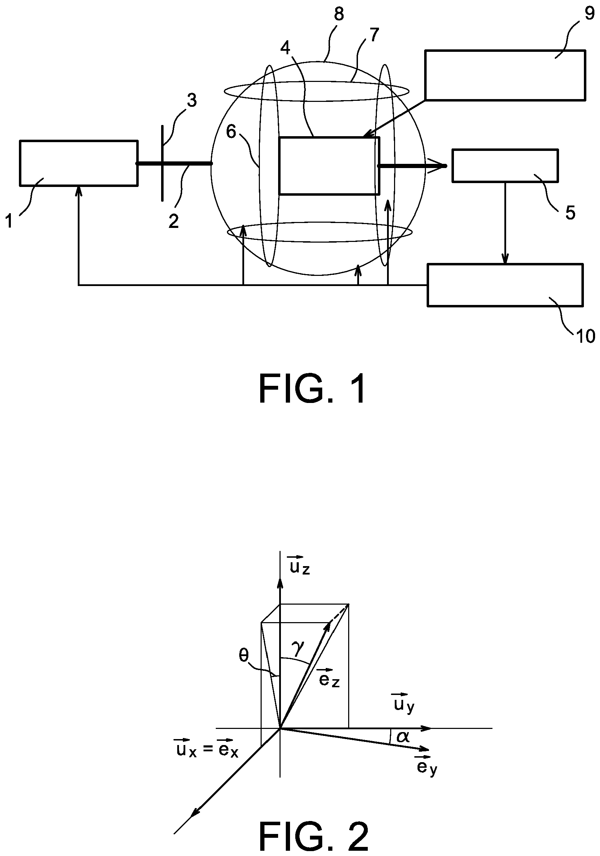

La figure 1 est un exemple de mise en oeuvre du procédé de l'invention. Cette figure 1 illustre un magnétomètre vectoriel qui comprend un laser (1) émetteur d'un faisceau (2). Le faisceau (2) passe successivement par un polariseur rectiligne (3) et par une cellule (4) emplie d'hélium 4 qu'il soumet à un pompage optique. Une photodiode (5) recueille la lumière restituée par le contenu de la cellule (4). Le dispositif comprend trois bobines (6, 7 et 8) fournissant des champs magnétiques dans trois axes nominalement orthogonaux, un générateur de radiofréquences (9) et une carte électronique (10) permettant de commander le laser (1) et les courants passant dans les bobines (6, 7 et 8) selon les besoins du procédé, pour la calibration ou d'autres raisons (compensation de champ ambiant, création de champ de stabilisation, etc.). Des appareils et des procédés où le champ magnétique ambiant est corrigé de façon efficace par application d'un champ magnétique statique artificiel d'intensité et de direction idoines sont décrits dans les documents FR-A-2 924 826 et 2 924 827, auxquels il est fait référence puisque leur enseignement peut être repris ici. Plusieurs courants peuvent passer simultanément dans chacune des bobines (6, 7 et 8) à des fréquences différentes. Le générateur de radiofréquences (9) émet des ondes électromagnétiques à la fréquence de Larmor dans l'invention, encore par l'intermédiaire des bobines (6, 7 et 8).

La figure 2 illustre les paramètres utilisés dans la suite de l'exposé. Ce sont les trois angles $\alpha$, $\gamma$, $\theta$ entre les axes $(\vec{e}_x, \vec{e}_y, \vec{e}_z)$ des bobines (6, 7, 8) définis par rapport à un repère orthonormé direct $(\vec{u}_x, \vec{u}_y, \vec{u}_z)$. L'orientation relative du repère $(\vec{e}_x, \vec{e}_y, \vec{e}_z)$ de l'instrument, défini par les directions de ces axes par rapport au repère orthonormé est définie comme suit : $\vec{e}_x$ coïncide avec $\vec{u}_x$, $\vec{e}_y$ est contenu dans le plan $(\vec{u}_x, \vec{u}_y)$ et forme un angle $\alpha$ avec $\vec{u}$, et les projections de $\vec{e}_z$ sur les plans $(\vec{u}_x, \vec{u}_z)$ et $(\vec{u}_y, \vec{u}_z)$ font les angles $\gamma$ et $\theta$ avec $\vec{u}_z$. Les vecteurs de base du repère des bobines $(\vec{e}_x, \overline{e}_y, \vec{e}_z)$ s'expriment donc dans le repère orthonormé $(\vec{u}_x, \vec{u}_y, \vec{u}_z)$ suivant les relations suivantes :

$$\vec{e}_x \; = \; \vec{u}_x \; ;$$

$$\vec{e}_y \;=\; -\sin\alpha \star \vec{u}_x \;+\; \cos\alpha \star \vec{u}_y \;;$$

$$\vec{e}_z \;=\; \frac{\tan\theta}{\sqrt{1+\tan^2\theta+\tan^2\gamma}}\star\vec{u}_x \;+\; \frac{\tan\gamma}{\sqrt{1+\tan^2\theta+\tan^2\gamma}}\star\vec{u}_y+\; \frac{1}{\sqrt{1+\tan^2\theta+\tan^2\gamma}}\star\vec{u}_z \,.$$

L'objet de la procédure de calibration est de permettre l'évaluation avec précision d'une part des fonctions de transfert (coefficients de gain) entre le champ magnétique et le courant, notées $T_x$, $T_y$, $T_z$ pour les bobines (6, 7 et 8) et d'autre part les écarts à l'orthogonalité entre leurs directions respectives. Pour ce faire, on engendre des mesures magnétiques scalaires avec l'instrument atomique en injectant des courants successivement dans chacune des bobines (6, 7 et 8) puis simultanément dans plusieurs d'entre elles. Ce choix permet en outre de garantir que, pour chaque série de mesures, l'amplitude des signaux de résonance de la lumière du faisceau 2 à la fréquence de Larmor soit suffisante pour obtenir un rapport signal sur bruit compatible avec la précision requise. Le choix de l'ordre de grandeur des champs scalaires à engendrer découle de la précision attendue pour la calibration des bobines (6, 7 et 8). A titre d'exemple pour garantir une précision absolue de 0,1nT dans un champ dont le module pourrait atteindre 5 $\mu$T, il est nécessaire de déterminer les fonctions de transfert courant sur champ magnétique à mieux que $2.10^{-5}$ et les écarts à l'orthogonalité au millidegré près. Nous supposerons dans la suite que la direction $\vec{e}_0{}^*$ de polarisation des photons dans le cas d'une polarisation rectiligne est colinéaire à $\vec{e}_x$.

La procédure dans l'exemple de la figure 1 sera détaillée dans le cas de la bobine (6) d'axe $\vec{e}_x$, la détermination des fonctions de transfert des deux autres bobines (7 et 8) étant en tout point similaire.

Le champ artificiel étant créé dans la direction $\vec{e}_x$ le champ de radiofréquences grâce auquel sera induite une résonance selon la fréquence du spin ou la fréquence de Larmor pourrait être appliqué indifféremment dans les deux autres axes $\vec{e}_y$ ou $\vec{e}_z$.

On injecte un courant $i_x$ successivement positif et négatif dans la bobine (6) et on mesure dans chaque cas la fréquence de résonance F du magnétomètre opérant en mode scalaire. Le module du champ magnétique vaut alors $B_{\pm i_x} = |B_x \pm i_x T_x|$, où $B_x$ est la composante du champ local dans la direction de l'axe $\vec{e}_x$, en négligeant les composantes du champ local dans le plan perpendiculaire. Il est à noter que ces composantes peuvent toujours être compensées au préalable grâce à des méthodes de mesures vectorielles connues, exposées notamment dans la thèse de Gravarand et autres « On the calibration of a vectorial 4He pumped magnetometer » paru dans Earth, planets and space, 2001, vol.53, n°10, pages 949 à 958, la thèse d'état de Dupont-Roc de 1972 « Etude de quelques effets liés au pompage optique en champ faible » et les demandes FR-A-2 924 826 et 2 924 827 déjà mentionnées. Pour une précision de calibration de $10^{-6}$ il est nécessaire que le champ magnétique transversal soit inférieur à $10^{-3}$ fois le champ magnétique $i_x T_x$ engendré par la bobine concernée.

On en déduit le système d' équations suivant :

$$\begin{cases} B_{+i_x} \;=\; B_x + i_x T_x \\ B_{-i_x} \;=\; B_x - i_x T_x \end{cases}$$

grâce auquel on détermine immédiatement $T_x$, $i_x$ étant connu.

Les effets des fluctuations du champ magnétique ambiant pendant cette phase d'étalonnage peuvent être atténués en répétant à plusieurs reprises ces mesures alternées. Le cas échéant, une dérive de la projection $B_x$ du champ ambiant peut être estimée pour améliorer la précision des calculs.

Ainsi qu'on l'a mentionné, le même procédé est répété pour les autres bobines (7 et 8).

On décrit ci-après comment déterminer les écarts à l'orthogonalité des trois bobines (6, 7 et 8). On procède comme précédemment à des séquences de mesures de champs scalaires correspondant à des champs artificiels créés par les bobines (6, 7 et 8), en utilisant ici des combinaisons de paires de bobines choisies de manière à garantir une amplitude de signal permettant la mesure avec la résolution voulue.

Pour la détermination de l'angle $\alpha$ entre $\vec{u}_y$ et $\vec{e}_y$, on injecte des courants dans les bobines (6 et 7) d'axes $\vec{e}_x$ et $\vec{e}_y$ selon la séquence {$+i_x+i_y$ ; $-i_x+i_y$ ; $-i_x-i_y$ ; $+i_x-i_y$}, en combinant les deux valeurs de courant de chacune des bobines actives selon les quatre états possibles. Les courants $i_x$ et $i_y$ sont choisis de sorte que le module du champ soit de 70% du courant appliqué lors des phases d'étalonnage des fonctions de transfert des bobines.

On obtient alors le système d'équations suivant :

$$\begin{cases} (B_{ix+iy})^2 - (B_{-ix+iy})^2 = 4i_xT_x(B_x - i_yT_y\sin\alpha) \\ (B_{ix-iy})^2 - (B_{-ix-iy})^2 = 4i_xT_x(B_x + i_yT_y\sin\alpha) \end{cases}$$

dont on déduit immédiatement $\sin\alpha$.

Pour la détermination des angles $\theta$ et $\gamma$ qui caractérisent la direction de $\vec{e}_z$ dans le repère orthonormé ($\vec{u}_x$, $\vec{u}_y$, $\vec{u}_z$), des mesures conjointes sont nécessaires. On effectue donc successivement, d'après des notations semblables à celles qui précèdent, les deux séquences suivantes à quatre états $\{i_x+i_{z/2} ; -i_x+i_{z/2} ; -i_x-i_{z/2} ; +i_x-i_{z/2}\}$ et $\{i_y+i_{z/2} ; -i_y+i_{z/2} ; -i_y-i_{z/2} ; +i_y-i_{z/2}\}$. Les courants $i_x$, $i_y$ et $i_z$ seront choisis de telle sorte que le module des champs qu'ils créent soit environ de 50 $\mu$T, d'où $i_x$, $i_y$ voisins de 80% des courants appliqués lors des phases d'étalonnage des fonctions de transfert des bobines (6, 7 et 8) et $i_{z/2}$ proche de 40% de cette valeur.

On obtient alors les systèmes d'équations suivant :

$$\begin{cases} (B_{ix+iz/2})^2 - (B_{-ix+iz/2})^2 = 4i_xT_x(B_x + \Theta * i_zT_z) \\ (B_{ix-iz/2})^2 - (B_{-ix-iz/2})^2 = 4i_xT_x(B_x - \Theta * i_zT_z) \end{cases} \quad (I)$$

$$\begin{cases} (B_{iy+iz/2})^2 - (B_{-iy+iz/2})^2 = 4i_yT_y\{\cos\alpha[B_y + \Gamma * i_zT_z] - \sin\alpha[B_x + \Theta * i_zT_z]\} \\ (B_{iy-iz/2})^2 - (B_{-iy-iz/2})^2 = 4i_yT_y\{\cos\alpha[B_y - \Gamma * i_zT_z] - \sin\alpha[B_x - \Theta * i_zT_z]\} \end{cases} \quad (II)$$

où

$$\Theta = \frac{\tan\theta}{2\sqrt{1+\tan^2\theta + \tan^2\gamma}} \quad et \quad \Gamma = \frac{\tan\gamma}{2\sqrt{1+\tan^2\theta + \tan^2\gamma}}.$$

On en déduit alors successivement $\Theta$ et $\Gamma$ puis $\theta$ et $\gamma$, ce qui clôt la phase d'étalonnage.

De façon analogue à ce qui précède, la composante du champ magnétique local qui est orthogonale au champ magnétique engendré pour les bobines est négligée ou compensée, et le champ de radiofréquences est orthogonal à ce champ (il peut être appliqué par la troisième bobine, ici 8, d'axe $\vec{e}_z$).

L'invention permet ainsi de pallier les dérives des fonctions de transfert des instruments atomiques et de calibrer les bobines de ces instruments en champ magnétique faible $(B < \frac{2\pi.f_R}{\gamma})$ dans lequel les mesures scalaires ne sont pas possibles si le temps de fréquence de relaxation $f_R$ des spins est supérieure à la fréquence de Larmor f ($f = B \cdot \frac{\gamma}{2\pi}$ et $\frac{\gamma}{2\pi} = 28,04$ Hz/$\mu$T pour l'hélium 4). L'invention permet de ne pas employer d'instrument supplémentaire et d'obtenir la mesure de référence au plus près de l'instrument à calibrer. Elle améliore ainsi la qualité de la calibration. Elle permet d'utiliser des instruments atomiques en magnétomètre puisqu'en plus de l'estimation de la fonction de transfert courant sur champ de la bobine considérée, on obtient également une mesure de la valeur de la composante $B_x$, $B_y$ ou $B_z$ du champ local selon cette direction.

La méthode peut s'appliquer aux gaz de type alcalin ou hélium. La polarisation de la lumière et la méthode de détection doivent être adaptées à la direction du champ magnétique imposé par les bobines. Il est à noter que la méthode peut aussi s'appliquer en polarisation circulaire à condition qu'ils aient alternativement, en fonction de la direction du champ magnétique, différents modes de fonctionnement des magnétomètres afin de garantir des conditions de mesures magnétiques selon le tableau II donné plus loin. Enfin, l'invention permet de ne pas être tributaire de l'amplitude ni de la direction du champ magnétique ambiant.

Le procédé a jusqu'ici été explicité pour un appareil plongé dans un champ magnétique ambiant relativement fort ($B_{x,y,z} \neq 0$ dans les équations). Il se simplifie si le champ est négligeable ou nul, arrêté par un blindage ou compensé par une des méthodes indiquées plus haut. On peut alors considérer que $B_{x,y,z} \approx 0$, et alors un seul courant (par exemple $i_x$ ou $-i_x$, au lieu de $i_x$ et $-i_x$) suffit pour déterminer le coefficient de gain ($T_x$) de la bobine associée, ici (6) en résolvant simplement une équation, telle que $B_{+ix} = i_xT_x$, au lieu d'un système à une paire d'équations. De même, les angles entre bobines peuvent être déterminés par des équations uniques au lieu de paires d'équation. Par exemple, $(B_{ix+iy})^2-(B_{-ix+iy})^2=4_{ix}T_x(-i_yT_y-i_x)$ suffit à donner $\alpha$, c'est-à-dire qu'il suffit d'injecter un courant $(i_y)$ dans une des bobines et deux courants $(i_x,-i_x)$ dans l'autre des bobines, selon deux états de combinaison $(i_x,i_y ; -i_x,i_y)$. Les mêmes remarques s'appliquent aux déterminations de $\theta$ et $\gamma$.

Le tableau I établit différentes techniques utilisables pour chaque bloc fonctionnel.

Tableau I

| Flux de photons polarisés | Gaz/ Spins | Moyen de génération de champ magnétique | Détection | Asservissements | Mesure/ Asservissement du champ magnétique |
|---|---|---|---|---|---|
| Diode laser + polariseur | He$^4$ (un plasma d'hélium doit être créé) | Généré par une bobine, au moins | Photo-détecteur | Digital Signal Processor | Scalaire, via la fréquence de Larmor |
| Lampe + Polariseur | Gaz Alcalin (Cs, Rb, K, etc.) | | | Ordinateur | Vectoriel, via un asservisse -ment en champ magnétique nul |
| VCSEL + polariseur | | | | $\mu$-processeur | Vectoriel, via la fréquence de Larmor |

La première ligne de ce tableau correspond en réalité à l'exemple décrit précédemment. Le laser (1) peut être une diode de type InGaAs de longueur d'onde de 1083 nm pour une puissance de 1 mW. La cellule (4) est emplie d'He$^4$ à 1 Torr. Elle est cylindrique, en pyrex et dispose d'un volume de 10 cm$^3$. Deux électrodes lui sont accolées et sont branchées au générateur (9) créant le plasma d'hélium ; les ondes de radiofréquence sont de l'ordre de 25 MHz de fréquence et 100 mW de puissance. Les bobines (6, 7 et 8) vectorielles produisent encore deux champs magnétiques à basse fréquence $H_\Omega \cos \Omega t$ et $H_\omega \cos \omega t$ où $\frac{\Omega}{2\pi} = 3\,\mathrm{kHz}$, $B_\Omega$= 50nT, $\frac{\omega}{2\pi} = 20\,\mathrm{kHz}$, $B_\omega$= 1000nT, ainsi que les champs de compensation du champ magnétique ambiant B. Enfin, les bobines (6, 7 et 8) produisent également le champ magnétique de radiofréquences à la fréquence de Larmor qui permet d'induire la résonance magnétique dans le milieu gazeux soumis au pompage optique. La fréquence exacte dépend de l'amplitude du champ magnétique à mesurer ($f = B.\frac{\gamma}{2\pi}$ où f est la fréquence du champ de radiofréquence et $\frac{\gamma}{2\pi} = 28,04$ Hz/nT comme on l'a vu).

Le tableau II indique quatre techniques, connues sous les noms de $M_x$, $M_z$, Bell & Bloom et CPT dans l'art, qui permettent aussi d'exploiter l'invention avec une polarisation circulaire de la lumière.

| Technique | $M_x$ | $M_z$ | Bell & bloom | CPT |
|---|---|---|---|---|
| Angle entre champ magnétique statique et direction du laser | 45° | 0° | 90° | 0° |
| Champ magnétique de radiofréquences | Angle de 90° avec le laser et le champ magnétique statique | Angle de 90° avec le laser et le champ magnétique statique | Absent | Absent |
| Commentaire | | | Modulation en intensité du laser | Modulation en intensité du laser |

**Revendications**

1. Procédé de calibration d'un appareil de mesure à fonctionnement atomique, ledit appareil comprenant :

   - une cellule emplie d'un milieu de mesure ;
   - un faisceau optique soumettant le milieu de mesure à un pompage optique ;
   - trois bobines électromagnétiques (6, 7, 8) composant trois paires de bobines électromagnétiques (6, 7 ; 6, 8 ; 7, 8) et générant chacune un champ magnétique axial dans la cellule, les axes des bobines faisant des angles entre eux ;

   le procédé étant **caractérisé en ce qu'**il comprend les étapes suivantes :

   - injection successive d'au moins un courant ($i_x, i_y, i_z$) dans chacune des bobines ;
   - mesure du champ magnétique généré par chacune des bobines ;
   - détermination d'un coefficient de gain (T) de chaque bobine, qui est un rapport entre le champ magnétique généré et le courant injecté ;
   - injection simultanée de courants dans chacune des paires desbobines électromagnétiques, suivant au moins deux états différents de combinaison desdits courants ($i_x\, i_y$ ; $-i_x\, i_y$ ; $-i_x\, -i_y$ ; $i_x\, -i_y$), lesdits états comprenant respectivement deux courants dans une des bobines et au moins un courant dans l'autre des bobinesde la paire de bobines électromagnétiques ;
   - mesure des champs magnétiques engendrés par lesdites combinaisons de courants, un champ magnétique ambiant étant négligé, arrêté par un blindage ou compensé ;
   - détermination d'au moins un des angles ($\alpha$, $\theta$, $\gamma$) entre les bobines de chacune des paires de bobines électromagnétiques d'après les champs magnétiques mesurés, les coefficients de gain et les courants injectés.

2. Procédé selon la revendication 1, comprenant une étape d'injection successive de deux courants ($i_x$, $-i_x$) de valeurs différentes et une étape de soustraction de deux mesures correspondantes de champs magnétiques colinéaires à la bobine.

3. Procédé selon l'une quelconque des revendications 1 ou 2, **caractérisé en ce qu'**il comprend, en l'absence d'étape de compensation de champ magnétique ambiant, une injection successive de deux courants pour chacune des bobines pour la détermination du coefficient de gain, et une injection simultanée de courants dans chacune des paires desdites bobines suivant quatre états différents de combinaison desdits courants, lesdits états comprenant respectivement deux courants différents dans chacune des deux bobines de la paire pour la détermination d'au moins un des angles ($\alpha$, $\theta$, $\gamma$) entre les bobines des paires.

4. Procédé selon la revendication 1 ou 2, dans lequel une étape de compensation du champ magnétique ambiant comprend les étapes suivantes :

   - génération de deux champs oscillants orthogonaux afin de régler en direction et en intensité le champ généré par chacune des bobines ;
   - génération d'un champ magnétique essentiellement statique par chacune des bobines ;
   - compensation du champ ambiant par ledit champ essentiellement statique par réglage du champ magnétique essentiellement statique engendré pour chacune des bobines.

5. Procédé selon l'une quelconque des revendications 1 à 4, dans lequel est prévue une étape de répétition successive de mesures du champ magnétique généré par chaque bobine.

6. Procédé de calibration d'un appareil selon l'une quelconque des revendications 1 à 5, **caractérisé en ce que** les champs magnétiques sont mesurés par une application de radiofréquences et une recherche d'une résonance du milieu gazeux relié à une fréquence de Larmor.


**Patentansprüche**

1. Verfahren zur Kalibrierung eines Messgeräts mit Atombetrieb, wobei das Gerät umfasst:

   - eine Zelle, die mit einem Messmilieu gefüllt ist;

- einen optischen Strahl, der das Messmilieu einem optischen Pumpen aussetzt;
- drei elektromagnetische Spulen (6, 7, 8), mit denen drei Paare von elektromagnetischen Spulen (6, 7; 6, 8; 7, 8) gebildet sind, und die jeweils ein axiales magnetisches Feld in der Zelle erzeugen, wobei die Achsen der Spulen Winkel miteinander einschließen;

wobei das Verfahren **dadurch gekennzeichnet ist, dass** es die folgenden Schritte umfasst:

- sukzessives Injizieren wenigstens eines Stroms ($i_x$, $i_y$, $i_z$) in jede der Spulen;
- Messen des magnetischen Felds, das durch jede der Spulen erzeugt wird;
- Bestimmen eines Verstärkungskoeffizienten (T) jeder Spule, der ein Verhältnis zwischen dem erzeugten magnetischen Feld und dem injizierten Strom ist;
- gleichzeitiges Injizieren von Strömen in jedes der Paare der elektromagnetischen Spulen gemäß wenigstens zwei verschiedenen Zuständen von Kombinationen der Ströme ($i_x$ $i_y$; -$i_x$ $i_y$; -$i_x$ -$i_y$; $i_x$ -$i_y$), wobei die Zustände jeweils zwei Ströme in einer der Spulen und wenigstens einen Strom in der anderen der Spulen des Paars von elektromagnetischen Spulen umfassen;
- Messen der magnetischen Felder, die durch die Kombinationen von Strömen erzeugt werden, wobei ein Umgebungsmagnetfeld vernachlässigt wird, durch eine Abschirmung abgehalten wird oder kompensiert wird;
- Bestimmen wenigstens eines der Winkel ($\alpha, \theta, \gamma$) zwischen den Spulen jedes der Paare von elektromagnetischen Spulen gemäß den gemessenen magnetischen Feldern, den Verstärkungskoeffizienten und den injizierten Strömen.

2. Verfahren nach Anspruch 1, umfassend einen Schritt des sukzessiven Injizierens von zwei Strömen ($i_x$, -$i_x$) mit unterschiedlichen Werten und einen Schritt des Subtrahierens von zwei entsprechenden Messungen von Magnetfeldern kolinear zur Spule.

3. Verfahren nach einem der Ansprüche 1 oder 2, **dadurch gekennzeichnet, dass** es in Abwesenheit eines Schritts des Kompensierens des Umgebungsmagnetfelds ein sukzessives Injizieren von zwei Strömen für jede der Spulen für die Bestimmung des Verstärkungskoeffizienten umfasst, sowie ein gleichzeitiges Injizieren von Strömen in jedes der Paare der Spulen gemäß vier unterschiedlichen Zuständen von Kombinationen der Ströme, wobei die Zustände jeweils zwei unterschiedliche Ströme in jeder der zwei Spulen des Paars für die Bestimmung wenigstens eines der Winkel ($\alpha, \theta, \gamma$) zwischen den Spulen der Paare umfassen.

4. Verfahren nach Anspruch 1 oder 2, bei dem ein Schritt des Kompensierens des Umgebungsmagnetfelds die folgenden Schritte umfasst:

- Erzeugen von zwei orthogonalen oszillierenden Feldern, um das durch jede der Spulen erzeugte Feld hinsichtlich Richtung und hinsichtlich Intensität zu regeln;
- Erzeugen eines im Wesentlichen statischen magnetischen Felds durch jede der Spulen;
- Kompensieren des Umgebungsfelds mittels des im Wesentlichen statischen Felds durch Regelung des erzeugten im Wesentlichen statischen magnetischen Felds für jede der Spulen.

5. Verfahren nach einem der Ansprüche 1 bis 4, bei dem ein Schritt des sukzessiven Wiederholens von Messungen des Magnetfelds vorgesehen ist, das durch jede Spule erzeugt wird.

6. Verfahren zur Kalibrierung eines Geräts nach einem der Ansprüche 1 bis 5, **dadurch gekennzeichnet, dass** die magnetischen Felder gemessen werden durch Anlegen von Funkfrequenzen und Suche nach einer Resonanz des gasförmigen Milieus in Verbindung mit einer Larmor-Frequenz.

## Claims

1. Method of calibrating a measurement apparatus with atomic functioning, said apparatus comprising:

- a cell filled with a measuring medium;
- an optical beam subjecting the measuring medium to optical pumping;
- three electromagnetic coils (6, 7, 8) making up three pairs of electromagnetic coils (6,7 ; 6,8 ; 7,8) and each generating a magnetic field axial to the cell, the axes of the coils having angles between them;

the method being **characterised in that** it comprises the following steps:

- successively injecting at least one current ($i_x$, $i_y$, $i_z$) in each of the coils;
- measuring the magnetic field generated by each of the coils;
- determining a gain coefficient (T) for each coil, which is a ratio between the magnetic field generated and the current injected;
- simultaneous injection of currents in each pair of electromagnetic coils, in accordance with at least two different states of combination of said currents ($i_x i_y$; $-i_x i_y$; $-i_x -i_y$; $i_x -i_y$), said states respectively comprising two currents in one of the coils and at least one current in the other coil in the pair of electromagnetic coils;
- measuring the magnetic fields generated by said combinations of currents, an ambient magnetic field being ignored, stopped by a shield or compensated for;
- determining at least one of the angles ($\alpha$, $\theta$, $\gamma$) between the coils of each of the pairs of electromagnetic coils according to the magnetic fields measured, the gain coefficients and the currents injected.

2. Method according to claim 1, comprising a step of successive injection of two currents ($i_x$, $-i_x$) of different values and a step of subtracting two corresponding measurements of magnetic fields colinear with the coil.

3. Method according to any one of claims 1 and 2, **characterised in that** it comprises, in the absence of compensating step for the ambient magnetic field, a successive injection of at least two currents for each of the coils, for the determining of the gain coefficient, and a simultaneous injection of currents in the coils in each of the pairs of the coils, in accordance with at least four different states of combination of said currents, said states respectively comprising two different currents in each of the two coils in the pair for the determining of at least one of the angles ($\alpha$, $\theta$, $\gamma$) between the coils in the pairs.

4. Method according to claim 1 or 2, in which a step of compensating for the ambient magnetic field comprises the following steps:

- generation of two orthogonal oscillating fields in order to adjust for direction and intensity the field generated by each of the coils;
- generation of a essentially static magnetic field by each of the coils;
- compensation for the ambient field by said essentially static field by adjusting the essentially static magnetic field generated for each of the coils.

5. Method according to any one of claims 1 to 4, in which there is provided a step of successive repetition of measurements of the magnetic field generated by each coil.

6. Method of calibrating an apparatus according to any one of claims 1 to 5, **characterised in that** the magnetic fields are measured by an application of radio frequency and a search for a resonance of the gaseous medium linked to a Larmor frequency.

FIG. 1

FIG. 2

**EP 2 426 563 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0462001 A
- FR 2924826 A

- FR 2924827 A